# EUROPEAN PATENT APPLICATION

(11) **EP 4 478 777 A1**
(43) Date of publication of application: **18.12.2024**
(21) Application number: 23179574.1
(22) Date of filing: 15.06.2023
(51) Int. Cl.: H04W 24/04, G01R 31/55, H01R 13/64, H04B 7/155, H04W 84/10

(54) **A SYSTEM FOR ENHANCING MOBILE TELEPHONY SERVICE COVERAGE INTERNAL A BUILDING**

(71) Applicant: Stella Doradus Europe Ltd, Portlaw, X91 NH59 County Waterford (IE)
(72) Inventor: Browne, James, County Waterford (IE); Browne, Naomi, County Waterford (IE); Browne, Edwina, County Waterford (IE); Browne, Francis, County Waterford (IE)
(74) Representative: O'Connor, Michael Donal

(57) **Abstract**

This invention relates to a system for enhancing the mobile telephony service coverage internal a building. The system comprises an external outdoor antenna, a repeater, and a plurality of indoor antennas connected to the repeater. The repeater and the indoor antennas each have a coaxial cable connector. Each of the indoor antennas is connected to the repeater by way of a dedicated coaxial cable, the dedicated coaxial cable being connected at its ends to the repeater coaxial cable connector and the indoor antenna coaxial cable connector. Each of the indoor antennas is provided with a coaxial cable connection detection circuit and a coaxial cable connection indicator. The detection circuit detects whether or not there is a closed circuit connection between the repeater and the indoor antenna, and the indicator indicates whether or not there is a closed circuit connection between the repeater and the indoor antenna.

## Description

### Introduction

This invention relates to a system and method for enhancing the mobile telephony service coverage internal a building. In addition, the invention relates to an indoor antenna, a repeater and a line amplifier for use in such a system and method.

Poor mobile telephony service coverage inside buildings is a significant problem. In order to address the poor coverage inside buildings, it is known to provide an external antenna outside the building to capture the desired signal where it is relatively strong, a repeater connected to the external antenna to amplify that captured signal, and a plurality of internal antennae distributed throughout the interior of the building, connected to the repeater, to disseminate the captured signal inside the building. In this way, the mobile telephony service coverage inside the building should be improved. However, despite these measures being taken to improve poor mobile telephony service coverage, it is common for the problem of poor service coverage inside the building to persist.

There are many reasons why the indoor mobile telephony service coverage may be poor. For example, it could be that the external antenna is pointing in the wrong direction and is capturing signals from "competing" towers. Alternatively, it could be that the outdoor antenna is installed in such a manner that the signals are coming across a large metal roof, or that there is a handrail in the way. Further still, it could be that there is a very high-power signal coming from one operator, but that is not the operator's signal that it is desired to repeat inside the building. These will result in poor strength and/or poor-quality signals being provided inside the building. However, these are only some of the reasons for sub-par systems.

Another, oft-overlooked problem is the connectivity of the internal antennae. Irrespective of how well the outdoor antenna is installed and positioned, or how high quality the downlink signal being amplified by the repeater is, if the amplified signal does not reach the indoor antennas, bad signal coverage will result inside the building. As a consequence, there will be one or more of dropped calls, bad voice quality, slow data speeds or even non-existent data speeds.

It has been found that is not uncommon to find that the co-axial cable connection between the repeater and the indoor antenna has not been assembled correctly. When investigated, the problem is usually a poorly assembled coaxial connector. A poorly assembled coaxial connector results in either an open circuit, or if some of the copper braid from the coaxial outer sheath has shorted the outer conductor to the inner conductor, a short circuit. Either way, the result is that there is a large signal power reduction (of the order of 20dB or more) going into the antenna, and as a consequence there is almost no indoor coverage improvement.

At present, the only way to be certain that the indoor antennae are correctly connected to the repeater is to use a spectrum analyzer with a good directional antenna, and to go around to all the indoor antennae, point the spectrum analyzer antenna at the indoor antenna, and measure the signal strength. Even with years of experience, and with both antennae almost touching, it can be very difficult to decide if the indoor antenna is functioning correctly. Generally speaking, due to the difficulty in correctly administering and interpreting the results of this test, the test is hardly ever done, and the problem antennae are usually not discovered. Instead, the installer relies on other correctly assembled internal antennae, if present, to hopefully provide the necessary coverage. In the Applicant's experience, in any given installation, it is very unusual not to find at least 10% of the internal antennas badly connected, and in some installations the number of internal antennas that are badly connected can be as high as 80%.

It is an object of the present invention to provide a system, method and apparatus that overcome at least one of the problems of the known offerings. It is a further object of the present invention to provide a useful alternative choice for the consumer.

### Statements of Invention

According to the invention there is provided a system for enhancing the mobile telephony service coverage internal a building comprising: an external outdoor antenna; a repeater connected to the external outdoor antenna; and a plurality of indoor antennas in turn connected to the repeater; the repeater and the plurality of indoor antennas each having a coaxial cable connector, each of the plurality of indoor antennas being connected to the repeater by way of a dedicated coaxial cable, the dedicated coaxial cable being connected at one of its ends to the repeater coaxial cable connector and connected at its other end to the indoor antenna coaxial cable connector, characterized in that: each of the plurality of indoor antennas is provided with: a coaxial cable connection detection circuit operable to detect a closed circuit connection between the repeater and the indoor antenna; and a coaxial cable connection indicator, responsive to the coaxial cable connection detection circuit, operable to indicate to an operator whether or not there is a closed circuit connection between the repeater and the indoor antenna.

By having such a system, the operator will be provided with an indication on the indoor antenna itself as to whether or not there is a good connection between the antenna and the repeater. It will not be necessary for the installer to provide a spectrum analyzer and interpret the result of the test in order to determine whether or not there is a good connection between the indoor antenna and the repeater. Instead, the installer will know immediately whether or not there is a problem with the connection and whether or not remedial work is required to the connection in order to improve the mobile telephony service coverage inside the building. Although a relatively simple solution, the present invention addresses a long-standing problem in the industry and saves considerable time, expense and resources, thereby significantly improving the installation process.

In one embodiment of the invention there is provided a system for enhancing the mobile telephony service coverage internal a building in which the coaxial cable connection detection circuit comprises a voltage detection circuit operable to detect the voltage on the inner conductor of the coaxial cable. This is seen as a very simple yet highly effective way of detecting whether or not the connection is faulty. It has been recognized that if there is a fault in the coaxial cable connector, the voltage on the inner conductor of the coaxial cable will be outside a desired range. By providing a voltage detection circuit, a fault may be detected in a simple, inexpensive and relatively straightforward manner, without having a significant detrimental impact on the performance of the internal antenna.

In one embodiment of the invention there is provided a system for enhancing the mobile telephony service coverage internal a building in which the voltage detection circuit comprises a light emitting diode (LED) connected to the inner conductor of the coaxial cable. The LED is seen as a simple and inexpensive solution that will not significantly impact the operation or performance of the internal antenna.

In one embodiment of the invention there is provided a system for enhancing the mobile telephony service coverage internal a building in which the coaxial cable connection indicator responsive to the coaxial cable connection detection circuit comprises a light emitting diode (LED). Again, the LED is seen as a simple and inexpensive solution that will not significantly impact the operation or performance of the internal antenna.

In one embodiment of the invention there is provided a system for enhancing the mobile telephony service coverage internal a building in which the repeater is provided with: a repeater coaxial cable connection detection circuit operable to detect a closed circuit connection between the repeater and the indoor antenna; and a repeater coaxial cable connection indicator, responsive to the coaxial cable connection detection circuit, operable to indicate to an operator whether or not there is a closed circuit connection between the repeater and the indoor antenna. This is seen as a particularly useful implementation of the present invention. In this way, the installer / operator will be able to determine whether or not there is a problem with the connection between the repeater and the internal antenna, irrespective of which end of the installation the installer is at. In this way, the installer at the repeater will also be able to tell whether or not the remotely located antenna (or line amplifier) is correctly connected. It is envisaged that the repeater will have a cable detection circuit and an indicator for each indoor port of the repeater. It will be understood that if the installer uses a splitter from one of the indoor ports, there could be two indoor antennas (or more if a further splitter, tap or line amplifier is used) connected through the splitter to one port of the repeater. In this case the detection circuit in the repeater will give a positive indication if both antennas are correctly connected, a positive indication if one antenna is correctly connected but the other is open circuit (this is not ideal and the installer would have to check both antennas to be certain both are correctly connected), and a negative indication if either or both antennas are short circuited.

In one embodiment of the invention there is provided a system for enhancing the mobile telephony service coverage internal a building in which the repeater coaxial cable connection detection circuit comprises a voltage detection circuit connected to an RF trace of the repeater. Again, this is seen as a very simple yet highly effective way of detecting whether or not the connection is faulty. It has been recognized that if there is a fault in the coaxial cable connector, the voltage will be outside a desired range. By providing a voltage detection circuit, a fault may be detected in a simple, inexpensive and relatively straightforward manner, without having a significant detrimental impact on the performance of the repeater.

In one embodiment of the invention there is provided a system for enhancing the mobile telephony service coverage internal a building in which the voltage detection circuit of the repeater coaxial cable connection detection circuit comprises a resistor and an inductor connected in series. This is seen as a simple and inexpensive circuit to provide for the detection of the voltage. The inductor allows DC onto the RF trace but does not allow RF to pass through. This ensures that we can apply DC which we want to measure without detrimentally affecting the RF performance of the repeater or line amplifier. The resistor limits the current to the LEDs in the antennae. If it was not there, and the voltage put onto the RF trace was much above the forward voltage drop of the LEDS, the current flow would be too high and would blow the LEDs. Accordingly, a resistor value is chosen which will allow enough current through to light the LEDS in several antennae (in the case splitters are used), while still not blowing the LED in the antenna in the case only one antenna is used.

In one embodiment of the invention there is provided a system for enhancing the mobile telephony service coverage internal a building in which the voltage detection circuit of the repeater coaxial cable connection detection circuit comprises a dual comparator circuit. Again, this is seen as a simple and effective circuit to provide that will be able to identify both open circuit and short circuit conditions. In this way, any faults on the connection can be detected with relative ease.

In one embodiment of the invention there is provided a system for enhancing the mobile telephony service coverage internal a building in which the repeater coaxial cable connection indicator comprises a light emitting diode (LED). An LED is a simple, inexpensive device that will not greatly impact the performance of the repeater yet will provide an intuitive, clear signal to the installer or the repair personnel trouble-shooting the poor mobile telephony service coverage. This indicator will suggest to them whether or not there is a problem with the internal hardware, rather than or in addition to a potential problem outside the building such as a poorly installed external antenna.

In one embodiment of the invention there is provided a system for enhancing the mobile telephony service coverage internal a building in which there is provided a line amplifier connected intermediate the repeater and the indoor antenna, the line amplifier having a line amplifier coaxial cable connection detection circuit operable to detect a closed circuit connection between the line amplifier and the indoor antenna; and a line amplifier coaxial cable connection indicator responsive to the coaxial cable connection detection circuit operable to indicate to an operator whether or not there is a closed circuit connection between the line amplifier and the indoor antenna. It will be understood that in certain installations, line amplifiers may be provided for port expansion reasons, or to mitigate for line loss of the coaxial cable. In those cases where a line amplifier is provided intermediate the repeater and the internal antenna, the internal antenna and the line amplifier will have the necessary apparatus to detect whether there is a closed circuit connection therebetween.

It is envisaged that the line amplifier will have a cable detection circuit and an indicator for each indoor port of the line amplifier. It will be understood that if the installer uses a splitter from one of the indoor ports, there could be two indoor antennas (or more if a further splitter, tap or line amplifier is used) connected through the splitter to one port of the line amplifier. In this case, the detection circuit in the line amplifier will give a positive indication if both antennas are correctly connected, a positive indication if one antenna is correctly connected but the other is open circuit (this is not ideal and the installer would have to check both antennas to be certain both are correctly connected), and a negative indication if either or both antennas are short circuited

In some installations, there are provided four indoor ports of the repeater and four indoor ports of the line amplifier. In those cases, the repeater and the line amplifier use identical circuits on their indoor ports. That is, there is provided a separate 220nH inductor, a 470ohm resistor, and a comparator circuit for each port. For the line amplifier port that connects to the repeater, there is provided a similar circuit as provided in the antenna. More specifically, there is provided an LED as the coaxial cable detection circuit plus the coaxial cable connection indicator, but with the addition of a 220nH inductor to tap the DC from the RF trace without affecting the RF performance. In the indoor antennae, the LED is a type with relatively long, thin wire legs. One of these legs is soldered to the coax center. The long wire legs act as inductors, and the thinness of the wire acts as a high impedance tap off, so very little RF power travels down to the diode, and as a consequence, the LED has very limited affect on the RF performance of the antenna. For the repeater port (i.e the "outdoor port") that connects to the outdoor antenna, it is possible to use the same circuit as for the repeater indoor ports.

In one embodiment of the invention there is provided a system for enhancing the mobile telephony service coverage internal a building in which the line amplifier further comprises a line amplifier coaxial cable connection detection circuit operable to detect a closed circuit connection between the line amplifier and the repeater; and a line amplifier coaxial cable connection indicator responsive to the coaxial cable connection detection circuit operable to indicate to an operator whether or not there is a closed circuit connection between the line amplifier and the repeater. In this way, the installer or repair personnel trouble shooting poor connectivity will be able to determine, at the location of the line amplifier, whether or not there is a problem with the connection intermediate the line amplifier and the internal antenna, and/or whether or not there is a problem with the connection intermediate the line amplifier and the repeater. If the connection between the repeater and the line amplifier is faulty, this could have the knock-on effect that a fault will be incorrectly signaled further downstream between the line amplifier and the internal antenna. By having such a system, it will be possible to identify the location of faults more quickly so that they can be addressed in an efficient manner.

In one embodiment of the invention there is provided an indoor antenna for a system for enhancing the mobile telephony service coverage internal a building, the indoor antenna comprising: a coaxial cable connector, characterized in that: the indoor antenna is provided with: a coaxial cable connection detection circuit operable to detect a closed circuit connection between the indoor antenna and one of a repeater and a line amplifier; and a coaxial cable connection indicator, responsive to the coaxial cable connection detection circuit, operable to indicate to an operator whether or not there is a closed circuit connection between the indoor antenna and the one of the repeater and the line amplifier. This is seen as a very useful indoor antenna to have that will enable an installer to more easily provide comprehensive mobile telephony service coverage internal a building, troubleshoot coverage issues faster than was heretofore the case, and results in less time, effort and complexity in identifying and resolving coverage issues.

In one embodiment of the invention there is provided a repeater for a system for enhancing the mobile telephony service coverage internal a building, the repeater comprising a coaxial cable connector, characterized in that: the repeater is provided with: a repeater coaxial cable connection detection circuit operable to detect a closed circuit connection between the repeater and one of an indoor antenna and a line amplifier; and a repeater coaxial cable connection indicator responsive to the repeater coaxial cable connection detection circuit operable to indicate to an operator whether or not there is a closed circuit connection between the repeater and the one of the indoor antenna and the line amplifier. This is seen as a very useful repeater to have that will enable an installer to more easily provide comprehensive mobile telephony service coverage internal a building, troubleshoot coverage issues faster than was heretofore the case, and results in less time, effort and complexity in identifying and resolving coverage issues.

In one embodiment of the invention there is provided a line amplifier for a system for enhancing the mobile telephony service coverage internal a building, the line amplifier comprising a coaxial cable connector, characterized in that: the line amplifier is provided with: a line amplifier coaxial cable connection detection circuit operable to detect a closed circuit connection between the line amplifier and an indoor antenna; and a line amplifier coaxial cable connection indicator responsive to the line amplifier coaxial cable connection detection circuit operable to indicate to an operator whether or not there is a closed circuit connection between the line amplifier and the indoor antenna. This is seen as a very useful line amplifier to have that will enable an installer to more easily provide comprehensive mobile telephony service coverage internal a building, troubleshoot coverage issues faster than was heretofore the case, and results in less time, effort and complexity in identifying and resolving coverage issues.

In one embodiment of the invention there is provided a method of enhancing the mobile telephony service coverage internal a building comprising the steps of: installing a system for enhancing the mobile telephony service coverage internal a building; inspecting each of the coaxial cable connection indicators in order to detect any coaxial cable connection faults; repairing the coaxial cable connection faults. By having such a method, any problems with the connections to the internal antennae, line amplifier and/or repeater can be detected with ease subsequent to installation or from the outset. By ensuring that the coaxial connections between the internal antenna, line amplifier, and/or repeaters are properly constructed and operational, this will help to provide a more comprehensive mobile telephony service coverage internal a building, and will assist an operator in troubleshooting problems with connectivity. The installer can rule out a faulty connection to an internal antenna as the reason for poor connectivity, thereby allowing the installer to get to the root cause of the problem faster and more efficiently than was heretofore the case.

### Detailed Description of the Invention

The invention will now be more clearly understood from the following description of some embodiments thereof given by way of example only with reference to the accompanying drawings, in which:-
Figure 1 is a diagrammatic representation of a first installation in which the system according to the invention is implemented;
Figure 2 is a diagrammatic representation of a second installation in which the system according to the invention is implemented;
Figure 3 is a diagrammatic representation of a coaxial cable connection detection circuit for an internal antenna;
Figure 4 is a diagrammatic representation of part of a coaxial cable connection detection circuit for a repeater;
Figure 5 is a diagrammatic representation of another part of a coaxial cable connection detection circuit for a repeater;
Figure 6 is a diagrammatic representation of an internal antenna connected to a repeater;
Figure 7 is a diagrammatic representation of an internal antenna disconnected from a repeater;
Figure 8 is a diagrammatic representation of components of an alternative configuration in which the system according to the invention is implemented;
Figure 9 is a diagrammatic representation of components of another alternative configuration in which the system according to the invention is implemented;
Figure 10 is a diagrammatic representation of parts of the coaxial cable connection detection circuitry for a repeater; and
Figure 11 is a diagrammatic representation of parts of the coaxial cable connection detection circuitry for a line amplifier.

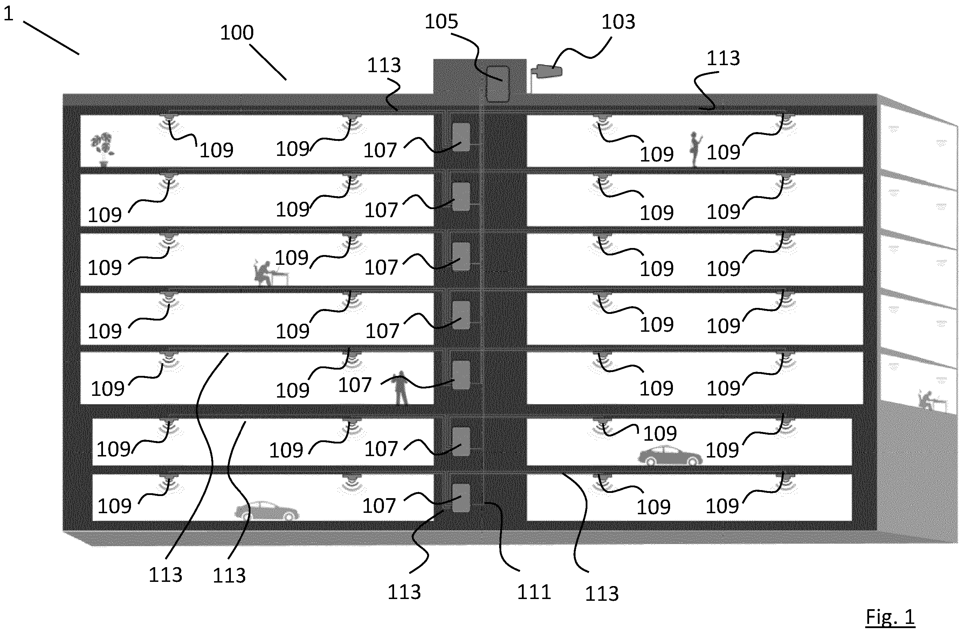

Referring to Figure 1, there is shown a building, indicated generally by the reference numeral 1, in which the system 100 for enhancing the mobile telephony service coverage internal the building according to the invention is implemented. The system 100 includes an external outdoor antenna 103, a repeater 105 connected to the external outdoor antenna 103, a plurality of line amplifiers 107 connected to the repeater, and a plurality of indoor antennas 109. The line amplifiers 107 are connected to the repeater by way of coaxial cables 111 and each of the internal antennae 109 are connected to one of the line amplifiers 107 by way of coaxial cables 113.

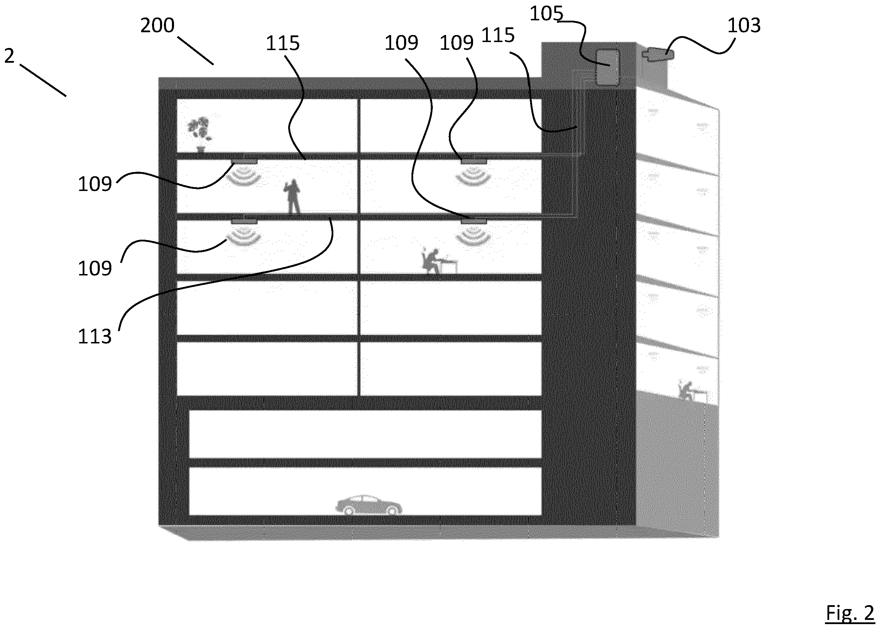

Referring now to Figure 2, there is shown an alternative building, indicated by the reference numeral 2, with a system 200 for enhancing the mobile telephony service coverage internal the building installed therein, where like parts have been given the same reference numeral as before. The system 200 differs from the system 100 in that there are no line repeaters provided in the system 200. Instead, the internal antennae 109 that are distributed throughout the building are connected directly to the repeater 105 by way of coaxial cables 115.

It will be understood that in Figures 1 and 2, the positioning of the internal antennae shown is not deemed to be limiting to the present invention. The internal antennae in Figure 1 are shown on every floor in a uniform manner and this is not necessarily the case. Certain areas of the building may require more or less internal antenna, and indeed it may not be necessary to have internal antennae on every floor of the building. The examples are merely used to illustrate typically layouts found in a building in which the systems according to the invention are installed.

In the embodiments shown in Figures 1 and 2, each of the internal antennae 109 is provided with a coaxial cable connection detection circuit (not shown) operable to detect a closed circuit connection between the indoor antenna 109 and one of the repeater 105 and the line amplifier 107, and a coaxial cable connection indicator (not shown). The coaxial cable connection indicator is responsive to the coaxial cable connection detection circuit and is operable to indicate to an operator whether or not there is a closed circuit connection between the indoor antenna 109 and the repeater 105 / line amplifier 107.

The repeaters 105 are provided with a repeater coaxial cable connection detection circuit (not shown) operable to detect a closed circuit connection between the repeater 105 and either the indoor antenna 109 or the line amplifier 107 (depending on the configuration, i.e. whether or not there are line amplifiers present), and a repeater coaxial cable connection indicator (not shown). The repeater coaxial cable connection is responsive to the coaxial cable connection detection circuit and is operable to indicate to an operator whether or not there is a closed circuit connection between the repeater 105 and the indoor antenna 109 / line amplifier 107.

In addition to the foregoing, the line amplifiers 107 of Figure 1 are provided with a line amplifier coaxial cable connection detection circuit (not shown) operable to detect a closed circuit connection between the line amplifier and the indoor antenna, and a line amplifier coaxial cable connection indicator (not shown). The line amplifier coaxial cable connection indicator is responsive to the coaxial cable connection detection circuit and is operable to indicate to an operator whether or not there is a closed circuit connection between the line amplifier and the indoor antenna. Furthermore, the line amplifiers 107 are each provided with a second line amplifier coaxial cable connection detection circuit (not shown) operable to detect a closed circuit connection between the line amplifier 107 and the repeater 105, and a second line amplifier coaxial cable connection indicator (not shown). The second line amplifier coaxial cable connection indicator is responsive to the second coaxial cable connection detection circuit operable to indicate to an operator whether or not there is a closed circuit connection between the line amplifier and the repeater.

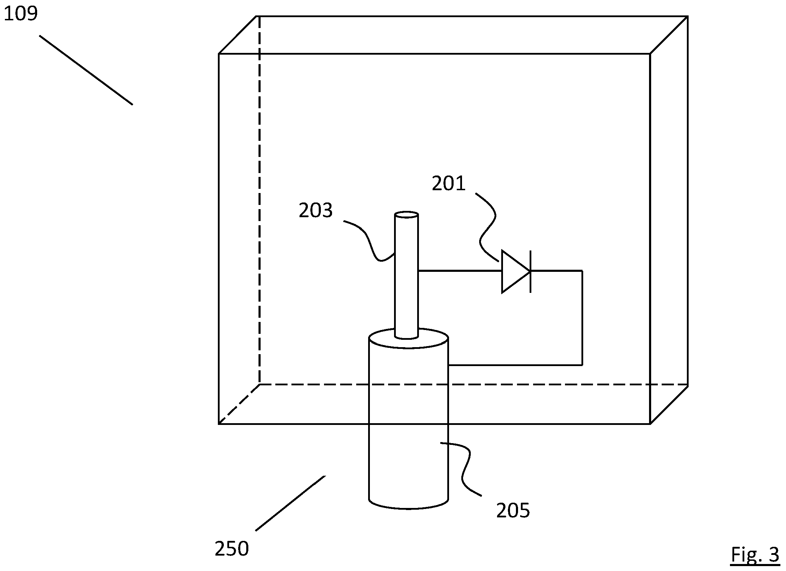

Referring now to Figure 3, there is shown a diagrammatic representation of a coaxial cable connection detection circuit, indicated generally by the reference numeral 250, for an internal antenna 109. The coaxial cable detection circuit 700 comprises an LED 201 connected between the inner conductor 203 of a coaxial cable 113, 115, and the outer conductor 205 of the coaxial cable 113, 115. The coaxial cable 113, 115 connects the internal antenna to one of a line amplifier and a repeater respectfully. In the configuration shown, the LED 201 performs the functions of both the coaxial cable connection detection circuit and the coaxial cable connection indicator.

The coaxial cable 113, 115, if assembled incorrectly, will result in either an open circuit or a short circuit. An open circuit usually arises due to the center pin in the coaxial connector is too far in the connector. When the center connector is correctly assembled, it is almost flush with the connector front face. However, often the connector is assembled recessed by a few mm from the front face into the connector. This can cause an open circuit.. A short circuit arises due to a small strand of copper wire shorting the outer conductor 205 of the coaxial cable to the inner center conductor 203 of the coaxial cable 113, 115. A simple continuity test can give a false positive. (It should be noted that the antenna will be of the type that there is no built-in short circuit between the center connector and ground, otherwise the antenna would always indicate a short circuit and the LED would not light. The only possible path to ground must be through the LED.)

Accordingly, the solution according to the present invention is to assemble an LED 201 in the indoor antenna 109. When a voltage is applied to the coaxial center 203 with the antenna correctly connected, this will light the LED 201. If, for example, a 4.5VDC is supplied through a 470 ohm resistor (not shown), the diode 201 will light and will pull the voltage on the coaxial center 205 to of the order of 2.7 volts (the forward voltage drop of the LED). If on the other hand there is an open circuit, the voltage will not reach the indoor antenna 109 and the LED 201 in the antenna will not light. If there is a short circuit in the coaxial cable, the voltage on the coaxial centre conductor will be pulled to zero, and will not light the LED 201 in the antenna 109. The design of the LED into the antenna has to be carefully considered, and the LED will affect many of the antenna properties. A slight degradation of the antenna performance can be expected.

As indicated above, it can be relatively difficult to minimize RF performance degradation caused by the incorporation of the LED into the antenna. Referring to Fig. 3, at the point where the diode is connected to the centre of the coaxial cable, there is effectively a split in the centre of the coaxial cable with one part going to the radiating elements of the antenna and the other part going from the center of the coax (which is carrying the RF power) going to the LED. So, where there is the join, there is effectively a splitter. We do not want the RF power to go down the leg to the diode. Instead, we want it to continue to all go to the radiating elements. In order to achieve this, we take advantage of the natural inductance of the long wire leg of the diode, plus the natural thinness of the diode wire in comparison to the wire from the centre of the coaxial cable ( which means the wire to the diode is of higher impedance than the wire from the coaxial cable). The long wire to the diode acts as an equivalent to the 220nH inductor.

It will be noted that we have to add only the LED into the internal antenna. This LED acts as both the coaxial cable detection circuit and the coaxial cable connection indicator. When 4.5V is applied to the LED, the LED forward voltage drop pulls the voltage to about 2.7V. The source of the 4.5V is from either the line amp or the repeater. The 4.5V is supplied through the 470 ohm resistor (and through the 220nH RF block inductor), back in the line amplifier or repeater respectively and limits the current so that the LED is not blown.

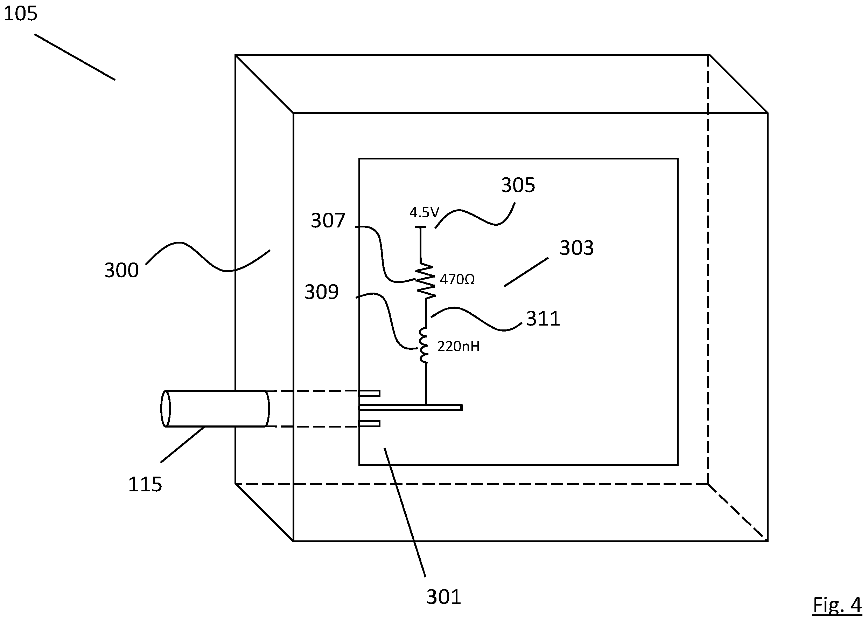

Back in the indoor side of the repeater and line amplifier, there is a 4.5V source. In Fig 4, at position 311, the voltage is monitored. If there is no internal antenna present, or there is an open circuit (coaxial connector fault) we will measure 4.5V. If there is a short circuit, we will measure 0V. If there is an internal antenna present and it is correctly connected, we will measure the forward voltage drop of the LED, i.e. 2.7V. We pass the voltage at position 311 to the dual comparator circuit. The output from this circuit drives the indicator LED in the repeater. Not shown is that this output must be passed through another 470 ohm resistor to limit the current to the LED in the repeater or line amplifier.

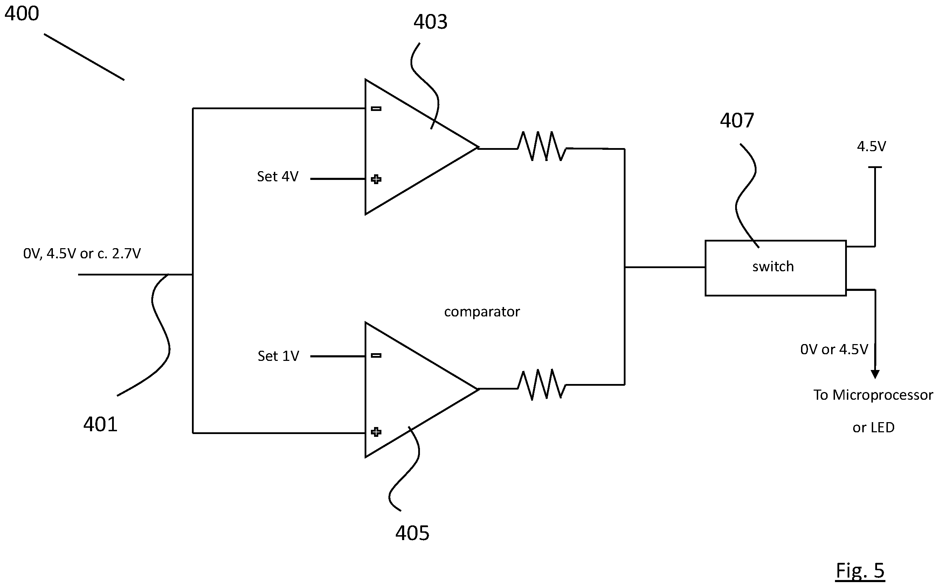

Referring now to Figure 4 and 5, there are shown parts of a coaxial cable connection detection circuit for a repeater 105. The same circuitry could be used in a line amplifier repeater (not shown). Referring first of all to Figure 4, there is shown a housing 300 of the repeater with a coaxial cable 111, 115 connected to the repeater. The coaxial cable 111, 115 is connected at its other end to one of an internal antenna (not shown) or a line amplifier (not shown). The coaxial cable RF trace 301 has a repeater coaxial cable connection detection circuit 303 connected thereto. The repeater coaxial cable connection detection circuit 303 comprises a voltage supply 305, a resistor 307, in this case a 470Ω resistor, an inductor 309, in this case a 220nH inductor, and a measurement point 311 intermediate the resistor 307 and the inductor 309. There is no DC voltage drop across the inductor. It only acts as an RF block. The voltage after the inductor will be the same as the voltage before the inductor.

In the embodiment shown in Figure 4, from the repeater 105, we can monitor the voltage on the RF trace 301 that connects to the coaxial cable. If the voltage on the RF trace 301 is 4.5V, we know there is no internal antenna correctly connected to the other end of the coaxial cable. It is basically an open circuit. If the voltage on the RF trace 301 is pulled to 0V, we know there is a short circuit. However, if the voltage on the RF trace is pulled to somewhere between 4.5V and zero volts (about 2.7V for the white LEDs used in the embodiments shown), we know there is an antenna correctly connected at the other end, and it is the forward voltage drop of the LED in the antenna that is pulling the voltage to 2.7V.

Referring to Figure 5, there is shown another component of the repeater coaxial cable connection detection circuit, in this case a comparator circuit, indicated generally by the reference numeral 400. The comparator circuit 400 comprises an input 401 (taken from point 311 of Figure 4), a pair of comparators 403, 405 and a switch 407. The comparators compare two input voltages and output a binary signal indicating which of the input voltages is larger. If the non-inverting (+) input is greater than the inverting (-) input, the output goes high. If the inverting input is greater than the non-inverting, the output goes low.

In use, the 4.5V is applied to the RF PCB trace (Figure 4) through a 470 ohm 0603 resistor and an inductor connected in series. In the embodiment shown, a wire wound 220nH 0603 size inductor is used. This allows the DC to pass to the RF trace, while blocking the cellular RF from getting back into the LED circuit. The voltage between the inductor and the resistor at measurement point 311 is measured. If there is no internal antenna connected to the other end of the coaxial cable 115, the measured voltage will be 4.5V. If there is a short circuit either in the internal antenna or the coaxial cable connector, the voltage at measurement point 311 will be 0V. However, if there is an internal antenna (not shown) having an integral LED connected to the other end of the coaxial cable 115, the voltage will drop to the forward voltage drop of the LED, usually to between 2V and 3.5V. In the present example, the voltage drops to of the order of 2.7V.

The monitored 2.7 volts is fed to the comparator circuit of Figure 5. The comparators 403, 405 are set up such that if the monitored voltage at the input 401 (fed from measurement point 311 of Figure 4) is between 1V and 3.5V, a low will be produced by the comparators. This low (0V) is sent to the switch 407, which is an active low switch, so that the switch produces a high which powers the LED (not shown) in the repeater.

If there is a short circuit, one of the comparators 403, 405 will produce a high, the other comparator a low. The combination produces about 2.5V. The switch 407 is active low, with a threshold of about 1V, so the switch will produce a high, keeping the LED off. If there is an open, the comparator outputs will be reversed, thereby also keeping the LED off.

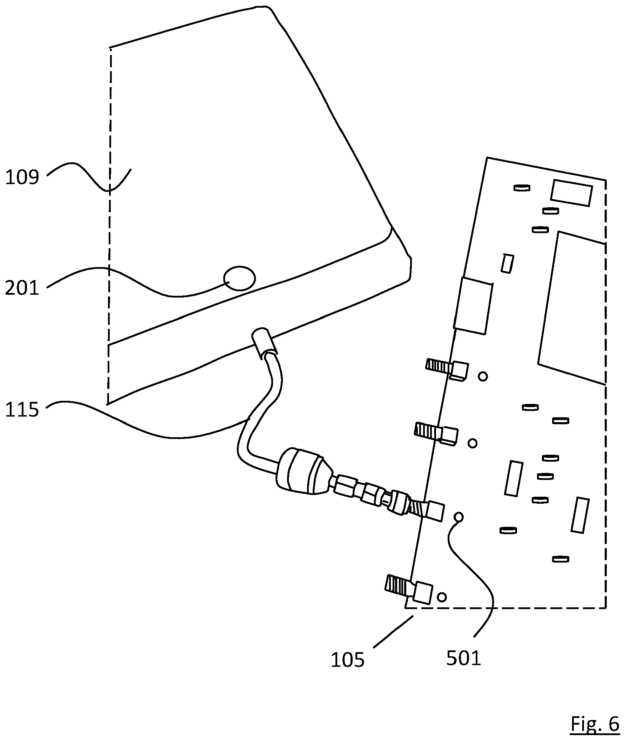

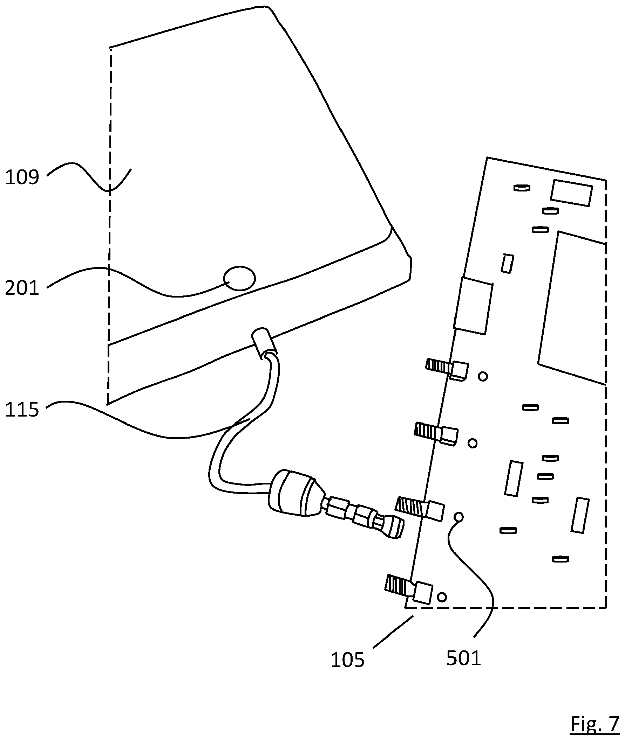

Referring now to Figures 6 and 7, in which there are shown diagrammatic representations of an internal antenna connected to a repeater (Figure 6); and an internal antenna disconnected from a repeater (Figure 7). In Figure 6, when the connections in both the internal antenna 109 repeater 105 have been properly constructed, and the coaxial cable is connected therebetween, the LED 201 in the internal antenna and the LED 500 in the repeater 105 will both light. On the other hand, if there is a problem with the connection, represented in Figure 7 with the coaxial cable simply disconnected from the coaxial cable connector of the repeater, both the LED 201 of the internal antenna 109 and the LED 500 of the repeater 105 will both remain off.

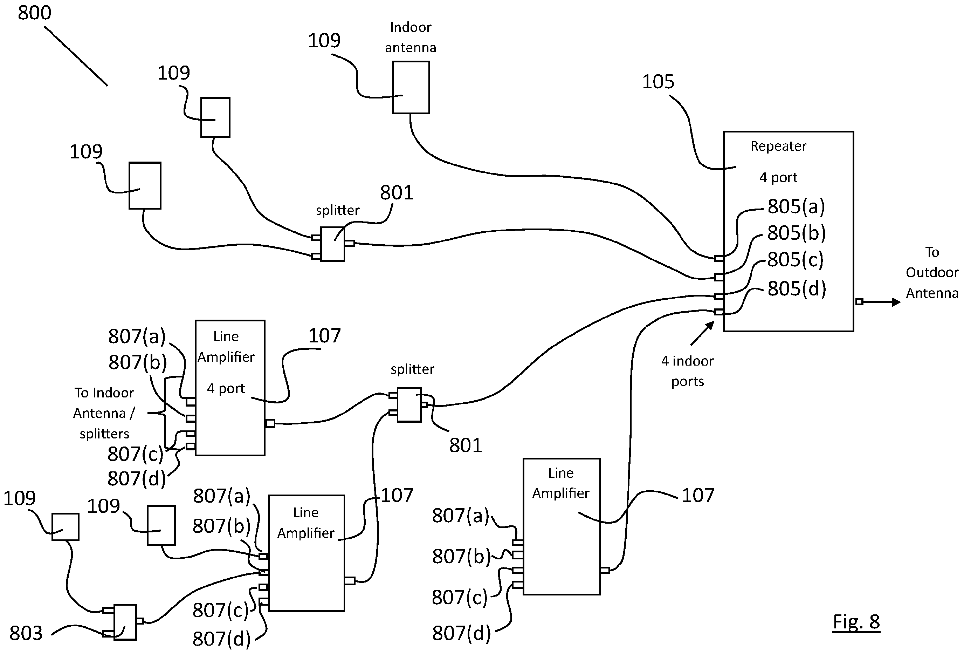

Referring now to Figure 8, there is shown a diagrammatic representation of components of an alternative configuration, indicated generally by the reference numeral 800, in which the system according to the invention may be implemented. In the embodiment shown, there are a number of splitters 801 and a tap 803 for expanding the system. As will be understood, a splitter distributes the incoming signal out to each output port of the splitter evenly, whereas a tap will apply different amount of loss to each of its output ports individually, so that when one cable connected to one of the output ports is shorter than another, the power of the output signal on the output ports will still be the same. The repeater 105 has a plurality of so-called "indoor" ports 805(a), 805(b), 805(c) and 805(d), namely ports that are intended for connection to equipment internal the building, and an "outdoor" port 807, namely a port intended for connection to the outdoor, external antenna. In the embodiment shown, the repeater has four indoor ports 805(a), 805(b), 805(c) and 805(d). There are further provided a plurality of line amplifiers 107. Each of the line amplifiers 107 has four inbound ports 807(a), 807(b), 807(c) and 807(d) (ports going to one of an internal antenna 109, a splitter 801 or a tap 803) and one outbound port 809 (a port going to the repeater in the case of the line amplifier).

Each of the repeater's indoor inbound ports 805(a), 805(b), 805(c) and 805(d) can be connected to one or more of the indoor antennas 109 through a splitter 801 or tap 803 so that more than four indoor antennas 109 can be installed. For example, the installer might connect each of the four indoor ports 805(a), 805(b), 805(c) and 805(d) of the repeater to a two-way splitter, thus increasing the number of indoor antennas that may be installed from four to eight. There is a coverage penalty for doing this in terms of range from the indoor antenna, but it can be useful if there are many small rooms or corridors to be covered in the installation. In this case, the splitters or taps must allow DC to pass through.

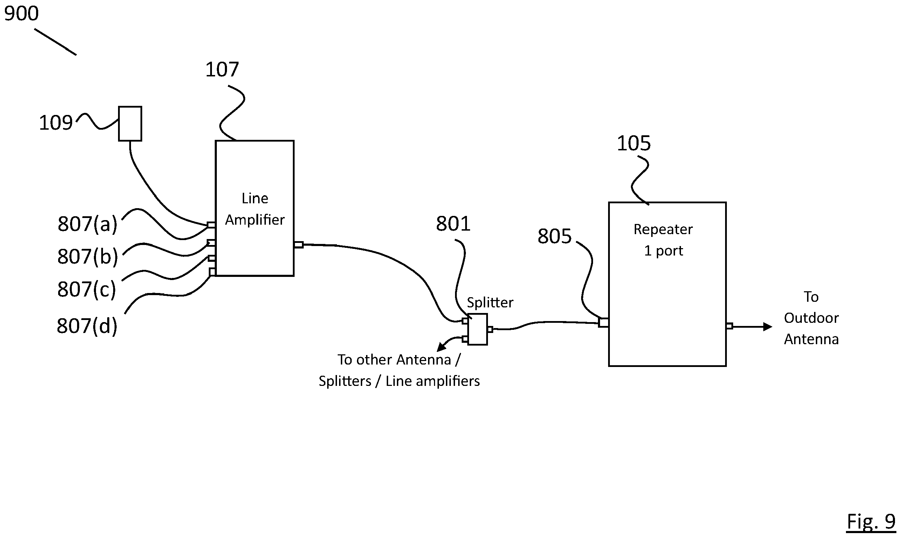

In the embodiment shown, indoor port 805(a) of the repeater 105 is fed directly to indoor antenna 109. Indoor port 805(b) is fed to splitter 801, which in turn is connected to two indoor antennae 109. The indoor port 805(c) of the repeater is connected to splitter 801 which in turn is connected to two line amplifiers 107(a), 107(b). Line amplifier 107(a) in turn has four inbound ports 807(a)-807(d), each of which can be connected to one of an indoor antenna, a splitter or a tap (not shown). The line amplifier 107(b) has an internal antenna 109 connected to the first line amplifier inbound port 807(a), and the second line amplifier inbound port 807(b) is connected to a tap 803 which in turn is shown connected to an internal antenna 109. The indoor port 805(d) is connected to a line amplifier 107 which is shown without any further equipment connected thereto,
Referring now to Figure 9, there is shown a diagrammatic representation of components of an alternative configuration, indicated generally by the reference numeral 900, in which the system according to the invention may be implemented, in which the repeater 105 only has one, rather than four, indoor port 805. The indoor port 805 of the repeater 105 is in turn connected to a splitter, which is connected to a line amplifier 107. The line amplifier is connected to an internal antenna 109. The remaining inbound ports of the line amplifier 807(b), 807(c) and 807(d) are shown disconnected for the time being, as is the second inbound port of the splitter. It will however be understood that each of those inbound ports could be connected to one of an internal antenna, a splitter or a tap.

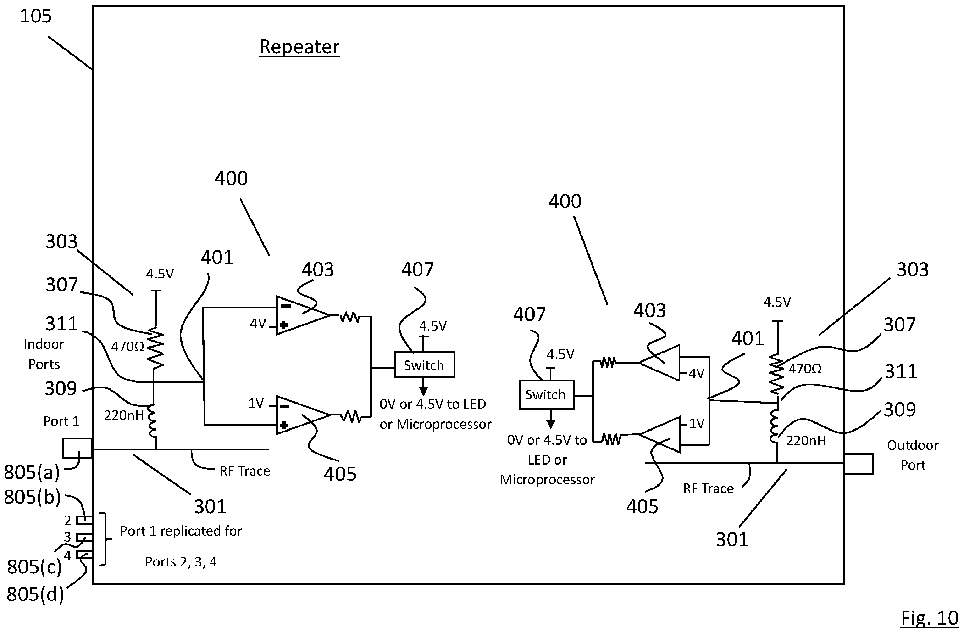

Referring now to Figure 10, there is shown a diagrammatic representation of parts of the coaxial cable connection detection circuitry for a repeater 105, where like parts have been given the same reference numeral as before. The repeater 105 has four indoor ports 805(a), 805(b), 805(c) and 805(d) leading to one of an internal antenna, a splitter and a tap. The circuitry is shown for only one of the four indoor ports, 805(a). This circuitry is replicated for each of the remaining indoor ports 805(b), 805(c) and 805(d). For the repeater 105, we have the 4.5V source/detection/connection indicator comparator switch circuit on all four indoor ports, and the same circuit on the outdoor antenna port side (this differs to the arrangement in the line amplifier).

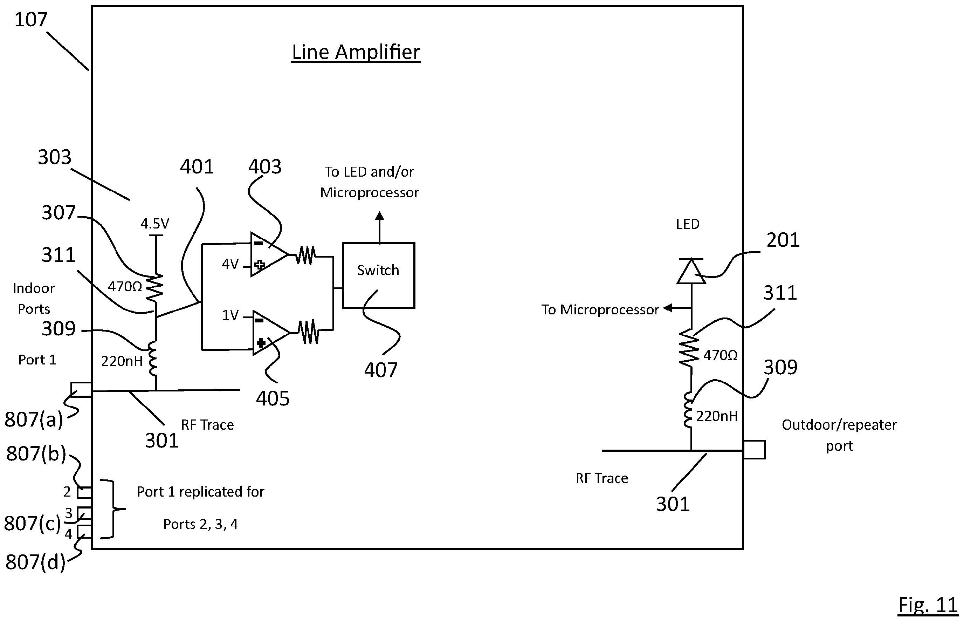

Referring now to Figure 11, there is shown a diagrammatic representation of parts of the coaxial cable connection detection circuitry for a line amplifier 107. For the line amplifier 107, there is provided one of the detection circuits similar to that shown for the repeater. Only one circuit for one of the ports 807(a) is shown however it will be understood that the same circuit would be provided on each of the remaining three indoor ports 807(b), 807(c) and 807(d) of the line amplifier. The circuits shown are both the 4.5V source and the detection/connection indicator comparator switch circuit. For the outward facing side connector of the line amplifier 107 (i.e. that side connected to the repeater 105), the circuitry is similar in many respects to the detection and indication circuitry in the internal antenna (not shown), in that there is an RF blocking inductor, a resistor and an LED. (In the internal antenna, the RF blocking inductor is in fact provided by way of the long thin legs of the LED, rather than by a separate dedicated device).

It will be understood that various modifications may be made to the embodiments described without departing from the invention. For example, a current measuring circuit could be used instead of a voltage measuring circuit. However, it is envisaged that a current measuring circuit would need extra components, and ultimately, that current would have to be converted into a representative voltage. Therefore, the voltage measuring system is seem as a simpler solution. In terms of simplicity and cost, the voltage method appears to be the preferred option. The teachings of the system and method according to the invention could also be implemented using actual data on the RF lines instead of the simple voltage levels taught herein, however again that would result in more complexity and expense.

In the embodiments described, the apparatus uses of the order of 10dBm maximum RF power on the downlink, and 20dBm on the uplink. 20dBm produces a maximum RF voltage of approximately 3volts. This would get clipped by the LED. However, the inductor greatly reduces the RF power. Preferable, the repeater is operating at less than 30dBm.

It will be understood that in certain installations, line amplifiers may be provided for port expansion reasons, or to mitigate for line loss of the coaxial cable. In those cases where a line amplifier is provided, one or more of the internal antennae will be connected to the line amplifier rather than directly to the repeater. Accordingly, in those circumstances, the internal antennae's coaxial cable connection detection circuit will be operable to detect a closed circuit connection between the line amplifier and the indoor antenna; and the coaxial cable connection indicator responsive to the coaxial cable connection detection circuit, will be operable to indicate to an operator whether or not there is a closed circuit connection between the line amplifier and the indoor antenna.

In this specification, the terms "comprise, comprises, comprised and comprising" and the terms "include, includes, included and including" are all deemed interchangeable and should be afforded the widest possible interpretation.

The invention is not solely limited to the embodiments hereinbefore described but may be varied in both construction and detail within the scope of the appended claims.

## Claims

1. A system for enhancing the mobile telephony service coverage internal a building comprising: an external outdoor antenna; a repeater connected to the external outdoor antenna; and a plurality of indoor antennas in turn connected to the repeater; the repeater and the plurality of indoor antennas each having a coaxial cable connector, each of the plurality of indoor antennas being connected to the repeater by way of a dedicated coaxial cable, the dedicated coaxial cable being connected at one of its ends to the repeater coaxial cable connector and connected at its other end to the indoor antenna coaxial cable connector, **characterized in that**: each of the plurality of indoor antennas is provided with: a coaxial cable connection detection circuit operable to detect a closed circuit connection between the repeater and the indoor antenna; and a coaxial cable connection indicator, responsive to the coaxial cable connection detection circuit, operable to indicate to an operator whether or not there is a closed circuit connection between the repeater and the indoor antenna.

2. A system for enhancing the mobile telephony service coverage internal a building as claimed in claim 1 in which the coaxial cable connection detection circuit comprises a voltage detection circuit operable to detect the voltage on the inner conductor of the coaxial cable.

3. A system for enhancing the mobile telephony service coverage internal a building as claimed in claim 2 in which the voltage detection circuit comprises a light emitting diode (LED) connected to the inner conductor of the coaxial cable.

4. A system for enhancing the mobile telephony service coverage internal a building as claimed in any preceding claim in which the coaxial cable connection indicator responsive to the coaxial cable connection detection circuit comprises a light emitting diode (LED).

5. A system for enhancing the mobile telephony service coverage internal a building as claimed in any preceding claim in which the repeater is provided with: a repeater coaxial cable connection detection circuit operable to detect a closed circuit connection between the repeater and the indoor antenna; and a repeater coaxial cable connection indicator, responsive to the coaxial cable connection detection circuit, operable to indicate to an operator whether or not there is a closed circuit connection between the repeater and the indoor antenna.

6. A system for enhancing the mobile telephony service coverage internal a building as claimed in claim 5 in which the repeater coaxial cable connection detection circuit comprises a voltage detection circuit connected to an RF trace of the repeater.

7. A system for enhancing the mobile telephony service coverage internal a building as claimed in claim 6 in which the voltage detection circuit of the repeater coaxial cable connection detection circuit comprises a resistor and an inductor connected in series.

8. A system for enhancing the mobile telephony service coverage internal a building as claimed in claim 6 or 7 in which the voltage detection circuit of the repeater coaxial cable connection detection circuit comprises a dual comparator circuit.

9. A system for enhancing the mobile telephony service coverage internal a building as claimed in any one of claims 5 to 8 in which the repeater coaxial cable connection indicator comprises a light emitting diode (LED).

10. A system for enhancing the mobile telephony service coverage internal a building as claimed in any preceding claim in which there is provided a line amplifier connected intermediate the repeater and the indoor antenna, the line amplifier having a line amplifier coaxial cable connection detection circuit operable to detect a closed circuit connection between the line amplifier and the indoor antenna; and a line amplifier coaxial cable connection indicator responsive to the coaxial cable connection detection circuit operable to indicate to an operator whether or not there is a closed circuit connection between the line amplifier and the indoor antenna.

11. A system for enhancing the mobile telephony service coverage internal a building as claimed in claim 10 in which the line amplifier further comprises a line amplifier coaxial cable connection detection circuit operable to detect a closed circuit connection between the line amplifier and the repeater; and a line amplifier coaxial cable connection indicator responsive to the coaxial cable connection detection circuit operable to indicate to an operator whether or not there is a closed circuit connection between the line amplifier and the repeater.

12. An indoor antenna for a system for enhancing the mobile telephony service coverage internal a building, the indoor antenna comprising: a coaxial cable connector, **characterized in that**: the indoor antenna is provided with: a coaxial cable connection detection circuit operable to detect a closed circuit connection between the indoor antenna and one of a repeater and a line amplifier; and a coaxial cable connection indicator, responsive to the coaxial cable connection detection circuit, operable to indicate to an operator whether or not there is a closed circuit connection between the indoor antenna and the one of the repeater and the line amplifier.

13. A repeater for a system for enhancing the mobile telephony service coverage internal a building, the repeater comprising a coaxial cable connector, **characterized in that**: the repeater is provided with: a repeater coaxial cable connection detection circuit operable to detect a closed circuit connection between the repeater and one of an indoor antenna and a line amplifier; and a repeater coaxial cable connection indicator responsive to the repeater coaxial cable connection detection circuit operable to indicate to an operator whether or not there is a closed circuit connection between the repeater and the one of the indoor antenna and the line amplifier.

14. A line amplifier for a system for enhancing the mobile telephony service coverage internal a building, the line amplifier comprising a coaxial cable connector, **characterized in that**: the line amplifier is provided with: a line amplifier coaxial cable connection detection circuit operable to detect a closed circuit connection between the line amplifier and an indoor antenna; and a line amplifier coaxial cable connection indicator responsive to the line amplifier coaxial cable connection detection circuit operable to indicate to an operator whether or not there is a closed circuit connection between the line amplifier and the indoor antenna.

15. A method of enhancing the mobile telephony service coverage internal a building comprising the steps of: installing a system for enhancing the mobile telephony service coverage internal a building as claimed in any one of claims 1 to 11 inclusive; inspecting each of the coaxial cable connection indicators in order to detect any coaxial cable connection faults; repairing the coaxial cable connection faults.
